# EUROPEAN PATENT SPECIFICATION

(11) **EP 2 706 575 B1**
(45) Date of publication and mention of the grant of the patent: **05.04.2017**
(21) Application number: 13165299.2
(22) Date of filing: 25.04.2013
(51) Int. Cl.: H01L 29/786, H01L 27/12

(54) **Thin film transistor substrate**
Dünnfilm-Transistor-Substrat
Substrat de transistor à couche mince

(30) Priority: 06.09.2012 KR 20120098686
(43) Date of publication of application: 12.03.2014
(73) Proprietor: Samsung Display Co., Ltd., Gyeonggi-do (KR)
(72) Inventor: Lee, Min-Jung, Seoul 109-104 (KR); Khang, Yoon-Ho, Gyeonggi-do 1411-401 (KR); Yu, Se-Hwan, Seoul (KR); Lee, Yong-Su, Gyeonggi-do 930-904 (KR); Shim, Jin-Young, Hwaseong-si, Gyeonggi-do No. 404, 150, (KR); Lee, Ji-Seon, Gyeonggi-do No. 204, 12-3 (KR); Choi, Kwang-Young, Incheon 208-402, 41 (KR)
(74) Representative: Dr. Weitzel & Partner

(56) References cited:
- WO-A1-03/036376
- WO-A1-2012/063436
- KR-A- 20080 047 179
- US-A1- 2005 275 038
- US-A1- 2011 175 674

## Description

### BACKGROUND

### FIELD

Exemplary embodiments of the present invention relate to a thin film transistor substrate and a method of manufacturing the thin film transistor. More particularly, exemplary embodiments of the present invention relate to a thin film transistor substrate including an oxide semiconductor, and a method of manufacturing the thin film transistor.

### DISCUSSION OF THE BACKGROUND

A thin film transistor is used for various electronic devices, such as a flat panel display. For example, the thin film transistor is used as a switching device or a driving element in the flat panel display including a liquid crystal display, an organic light emitting diode display, an electrophoretic display, or the like.

The thin film transistor includes a gate electrode, a source electrode, a drain electrode, and a channel layer forming a channel between the source electrode and the drain electrode. The channel layer includes a semiconductor layer including amorphous silicon, polycrystalline silicon, oxide semiconductor, or the like.

Amorphous silicon has a relatively low electron mobility, which may be about 1 to about 10cm²/V, so that a thin film transistor including amorphous silicon has relatively low driving characteristics. In contrast, polycrystalline silicon has a relatively high electron mobility, which may be about 10 to about hundreds cm²/V. However, a crystallization process is required for forming polycrystalline silicon. Thus, it is difficult to form a uniform polycrystalline silicon layer on a large-sized substrate, and resulting manufacturing costs are high.

Oxide semiconductors may be formed through a low-temperature process, and may be easily large-scaled, and have a high electron mobility. Thus, research is actively being conducted on thin film transistors which include an oxide semiconductor.

A gate electrode of a thin film transistor may form a parasitic capacitance with a source electrode or a drain electrode. The parasitic capacitance may cause signal delay of a data signal or a gate signal. Thus, in order to achieve a display panel having a high resolution and a large size, parasitic capacitance needs to be reduced.

### SUMMARY

Exemplary embodiments of the present invention provide a thin film transistor substrate capable of improving electrical characteristics of an oxide semiconductor.

Exemplary embodiments of the present invention also provide a method of manufacturing a thin film transistor substrate.

Additional features of the invention will be set forth in the description which follows, and in part will be apparent from the description, or may be learned by practice of the invention.

An exemplary embodiment of the present invention according to the claims discloses a thin film transistor substrate including a base substrate; an active pattern disposed on the base substrate and including a source electrode, a drain electrode, and a channel including an oxide semiconductor disposed between the source electrode and the drain electrode; a gate insulation pattern disposed on the active pattern, a gate electrode disposed on the gate insulation pattern and overlapping with the channel; and a light-blocking pattern disposed between the base substrate and the active pattern.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.
FIG. 1 is a plan view illustrating a thin film transistor substrate according to an exemplary embodiment of the present invention.
FIG. 2 is a cross-sectional view taken along the line I-I' of FIG. 1.
FIG. 3, FIG. 4, FIG. 5, FIG. 6, FIG. 7, FIG. 8, FIG. 9, FIG. 10, and FIG. 11 are cross-sectional views illustrating the thin film transistor substrate illustrated in FIGS. 1 and 2.
FIG. 12, FIG. 13, FIG. 14, FIG. 15, and FIG. 16 are cross-sectional views illustrating a method of manufacturing a thin film transistor substrate according to another exemplary embodiment of the present invention.
FIG. 17, FIG. 18, FIG. 19, FIG. 20, and FIG. 21 are cross-sectional views illustrating a method of manufacturing a thin film transistor substrate according to still another exemplary embodiment of the present invention.
FIG. 22 is a plan view illustrating a light-blocking pattern of the thin film transistor illustrated in FIG. 20.

### DETAILED DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers, regions, films, panels, etc., may be exaggerated for clarity. Like reference numerals denote like elements.

It will be understood that when an element such as a layer, film, region, or substrate is referred to as being "on" or "connected to" another element, it can be directly on or directly connected to the other element, or intervening elements may also be present. In contrast, when an element is referred to as being "directly on" or "directly connected to" another element, there are no intervening elements present. It will be understood that for the purposes of this disclosure, "at least one of X, Y, and Z" can be construed as X only, Y only, Z only, or any combination of two or more items X, Y, and Z (e.g., XYZ, XYY, YZ, ZZ).

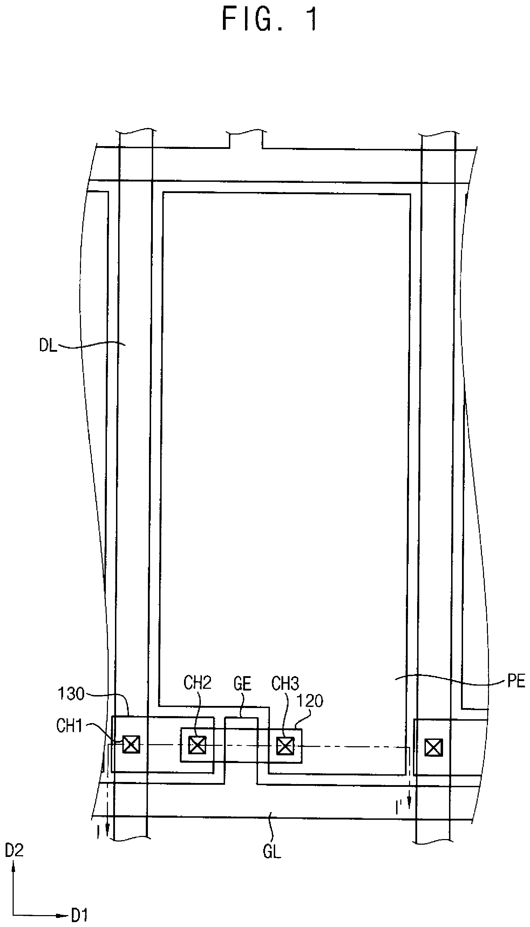

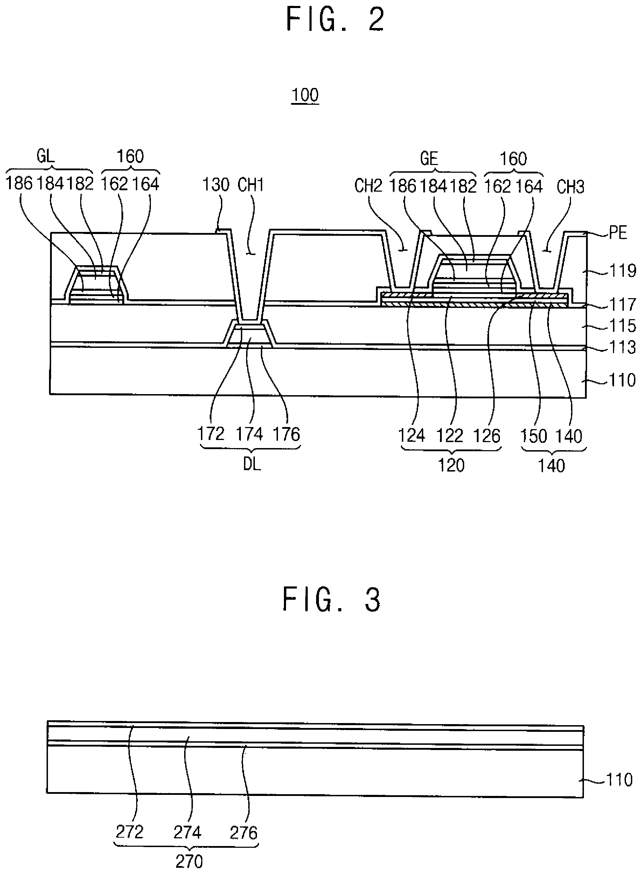

FIG. 1 is a plan view illustrating a thin film transistor substrate according to an exemplary embodiment of the present invention. FIG. 2 is a cross-sectional view taken along the line I-I' of FIG. 1.

Referring to FIGS. 1 and 2, a thin film transistor substrate 100 includes a base substrate 110, a gate line GL, a data line DL, and an active pattern 120.

The gate line GL extends in a first direction D1 in a plan view, and the data line DL extends in a second direction D2 crossing the first direction D1. The first direction D1 may be substantially perpendicular to the second direction D2.

The gate line GL is electrically connected to the gate electrode GE. The gate electrode GE may protrude from the gate line GL in the second direction D2.

In an exemplary embodiment, the gate line GL and the gate electrode GE may have a multiple-layered structure. Particularly, the gate line GL and the gate electrode GE includes an upper capping layer 182, a lower capping layer 186, and a metal layer 184 disposed between the upper capping layer 182 and the lower capping layer 186.

The upper capping layer 182 and the lower capping layer 186 include an oxide, and may have a Moh's hardness value greater than that of the metal layer 184 in order to protect the metal layer 184 in a cleaning process using a brush. The value of Moh's hardness may be equal to or greater than about 4.0, for example. The oxide may include at least one of indium zinc oxide (IZO), indium tin oxide (ITO), gallium zinc oxide (GZO), and zinc aluminum oxide (ZAO).

In an exemplary embodiment, the metal layer 184 may include copper, and the upper capping layer 182 and the lower capping layer 186 may include IZO.

Alternatively, the gate line GL may have a single-layered structure including copper, silver, chromium, molybdenum, aluminum, titanium, manganese, or an alloy thereof, or may have a multiple-layered structure including different materials. The gate line may include a copper layer and a titanium layer disposed on and/or under the copper layer.

The active pattern 120 includes a channel 122, a source electrode 124, and a drain electrode 126. The channel 122, the source electrode 124, and the drain electrode 126 are formed from a same layer to be continuously disposed in a same layer. The channel 122 is disposed between the source electrode 124 and the drain electrode 126.

The channel 122 overlaps with the gate electrode GE. The gate electrode GE may be disposed on the channel 122. A gate insulation pattern 160 may be disposed between the gate electrode GE and the channel 122. The gate insulation pattern 160 may extend under the gate line GL. Thus, the gate insulation pattern 160 may have substantially a same size and shape as the gate electrode GE and the gate line GL in a plan view.

In an exemplary embodiment, the gate insulation pattern 160 may have a multiple-layered structure. The gate insulation pattern 160 may include an upper gate insulation pattern 162 and a lower gate insulation pattern 164 including a different material from the upper gate insulation pattern 162. Alternatively, the gate insulation pattern 160 may have a single layered structure including an insulation material (not shown).

In an exemplary embodiment, the thin film transistor substrate 100 further includes a pixel electrode PE electrically connected to the drain electrode 126.

The data line DL is formed on the base substrate 110, is spaced apart from the source electrode 124, and is electrically connected to the source electrode 124. The data line DL is electrically connected to the source electrode 124 through a connection electrode 130. In an exemplary embodiment, the data line DL has a multiple-layered structure substantially similar to the gate line GL. The data line DL may include an upper capping layer 172, a lower capping layer 176, and a metal layer 174 disposed between the upper capping layer 172 and the lower capping layer 176. The upper capping layer 172 and the lower capping layer 176 may include an oxide.

In an exemplary embodiment, the metal layer 174 may include copper, and the upper capping layer 172 and the lower capping layer 176 may include IZO. Alternatively, the data line DL may have a multiple-layered structure having a plurality of metal layers including different materials, or a single-layered metal structure (not shown).

In an exemplary embodiment, the gate line GL, the gate electrode GE, and the data line DL may have a large taper angle to increase an opening ratio of a display substrate. The gate line GL, the gate electrode GE, and the data line DL may have a taper angle equal to or greater than about 60°. The taper angle may be equal to or more than about 70°.

A data insulation layer 133 is formed on the base substrate 110 to cover the data line DL. A first planarizing layer 115 is disposed on the data insulation layer 113.

In an exemplary embodiment, the data line DL may have a relatively large taper angle and thickness to decrease a signal delay, which may cause a large step portion on the substrate. The first planarizing layer 115 planarizes an upper surface of the base substrate 110 so that problems resulting from the step portion, such as disconnection of a signal line, may be prevented. The first planarizing layer 115 may be an insulation layer including an organic material.

The channel 122, the source electrode 124, the drain electrode 126, and the gate electrode GE form a thin film transistor. When a gate signal is applied to the gate electrode GE through the gate line GL, the channel 122 is turned into an electric conductor. Thus, a data signal provided from the data line DL is transferred to the pixel electrode through the connection electrode 130, the source electrode 124, the channel 122, and the drain electrode 126.

The thin film transistor substrate 100 may further include a passivation layer 117 covering the thin film transistor and the data insulation layer 113, and a second planarizing layer 119 covering the passivation layer 117. The pixel electrode PE and the connection electrode 130 are formed on the second planarizing layer 119.

The connection electrode 130 is connected to the data line DL through a first contact hole CH1 formed through the second planarizing layer 119, the passivation layer 117, the first planarizing layer 115, and the data insulation layer 113. Furthermore, the connection electrode 130 is connected to the source electrode 124 through a second contact hole CH2 formed through the second planarizing layer 119 and the passivation layer 117. The pixel electrode PE is connected to the drain electrode 126 through a third contact hole CH3 formed through the second planarizing layer 119 and the passivation layer 117.

The light-blocking pattern 140 is disposed under the channel 122. The light-blocking pattern 140 covers a lower surface of the channel 122 to prevent external light from entering the channel 122 through the lower surface of the channel 122. The light-blocking pattern 140 may overlap with an entire portion of the active pattern 120 including the channel 122. In an exemplary embodiment, the light-blocking pattern 140 and the active pattern 120 may be formed by using the same mask. In this manner, an edge of the light-blocking pattern 140 may coincide with an edge of the active pattern 120 in a plan view. Thus, the light-blocking pattern 140 may have substantially the same size and shape as the active pattern 120 in a plan view.

Alternatively, the light-blocking pattern 140 may overlap with an entire portion of the gate electrode GE as well as an entire portion of the active pattern 120 including the channel 122. When the gate electrode GE has a portion which does not overlap with the channel 122, the light-blocking pattern 140 may overlap with the portion of the gate electrode GE which does not overlap with the channel 122, as well as with the channel 122 itself. In this manner, the light-blocking pattern 140 may have a larger size than the active pattern 120 in a plan view.

In an exemplary embodiment, a buffer pattern 150 is disposed between the light-blocking pattern 140 and the active pattern 120. The light-blocking pattern 140 is formed on the first planarizing layer 115. Alternatively, an insulation layer (not shown) including an inorganic material such as silicon oxide or silicon nitride may be formed between the light-blocking pattern 140 and the first planarizing layer 115.

FIGS. 3 to 11 are cross-sectional views illustrating the thin film transistor substrate illustrated of FIGS. 1 and 2.

Referring to FIG. 3, a data metal layer 270 is formed on a base substrate 110. Examples of the base substrate 110 may include a glass substrate, a quartz substrate, a silicon substrate, a plastic substrate, or the like.

The data metal layer 270 includes an upper capping layer 272, a metal layer 274, and a lower capping layer 276. The upper capping layer 272 and the lower capping layer 276 may include an oxide such as IZO, and the metal layer 274 may include a metal such as copper. The thickness of the metal layer 274 may be about 1 *µ*m to about 3 *µ*m. The upper capping layer 272 and the lower capping layer 276 may have a Moh's hardness value greater than that of than the metal layer 274. For example, the Moh's hardness value of the upper capping layer 272 and the lower capping layer 276 may be equal to or greater than about 4.0.

The metal layer 274 may be formed through a sputtering process, and the upper capping layer 272 and the lower capping layer 276 may be formed through a chemical vapor deposition (CVD) process, a plasma enhanced chemical vapor deposition (PECVD) process, or the like.

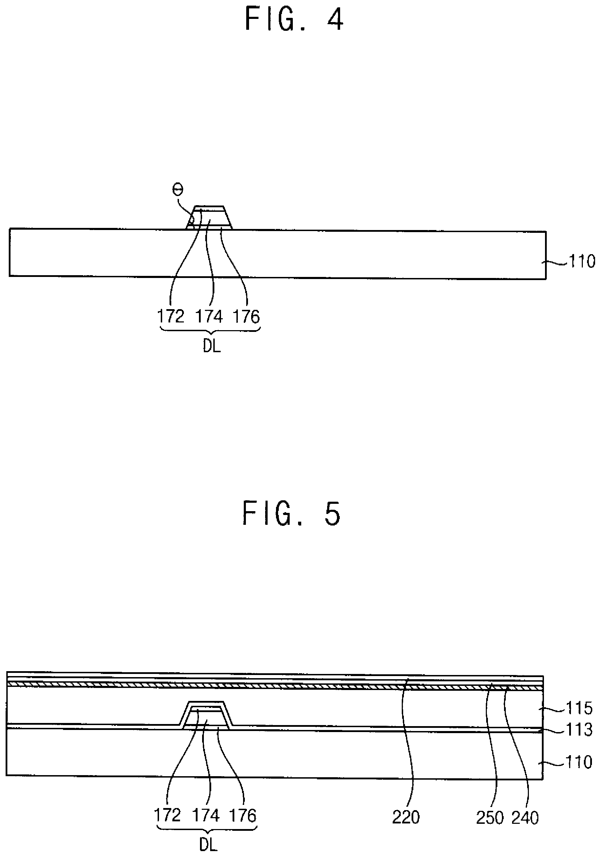

Referring to FIG. 4, the data metal layer 270 is patterned to form a data line DL.

A photoresist composition may be coated on the upper capping layer 272 to form a photoresist pattern having a shape corresponding to the data line DL. Thereafter, the upper capping layer 272, the metal layer 274, and the lower capping layer 276, which are not covered by the photoresist pattern, are sequentially etched to form the data line DL.

The upper capping layer 272, the metal layer 274, and the lower capping layer 276 may be etched in the same process using the same etchant. Thus, the data line DL may have a relatively large taper angle so that an opening ratio of a display substrate is increased. The taper angle may be defined as an angle formed by a lower surface and a side surface of the data line DL. Preferably, the taper angle θ of the data line DL may be equal to or greater than about 60°.

An etching composition for the etchant may include phosphoric acid, nitric acid, acetic acid, a copper salt, a fluorometallic acid, a nitrate, an acetate, and a water.

The data line DL includes an upper capping layer 172, a lower capping layer 176, and a metal layer 174 disposed between the upper capping layer 172 and the lower capping layer 176. The base substrate 110 having the data line DL may be cleaned by a brush after the data metal layer 270 is etched or after the data metal layer 270 is formed. Because the upper capping layer 172 including the oxide has a hardness greater than the metal layer 174, damage to the metal layer 174 resulting from friction with the brush may be prevented. Furthermore, the lower capping layer 176 may enhance adhesion between the data line DL and the base substrate 110.

Referring to FIG. 5, a data insulation layer 113, a fist planarizing layer 115, a light-blocking layer 240, a buffer layer 250, and an oxide semiconductor layer 220 are sequentially formed on the base substrate 110. The data insulation layer 113 covers the data line. The first planarizing layer 115 is disposed on the data insulation layer 113. The light-blocking layer 240 is disposed on the first planarizing layer 115. The buffer layer 250 is disposed on the light-blocking layer 240. The semiconductor layer 220 is disposed on the buffer layer 250.

In an exemplary embodiment, the data line DL may be formed prior to a thin film transistor. Furthermore, the data line DL may be embedded in the first planarizing layer 115.

In an exemplary embodiment, the first planarizing layer 115 includes an organic material. Thus, when the data line DL contacts the first planarizing layer 115, electrical characteristics of the data line DL may be deteriorated by, for example, metal diffusion, etc. The data insulation layer 113 includes an inorganic material and covers the data line DL to protect the data line DL. For example, the data insulation layer 113 may include at least one of silicon nitride, silicon oxide, and aluminum oxide, and may have a thickness of about 500Å to about 2,000Å.

A composition including a binder resin is coated on the data insulation layer 113. For example, the binder resin may include a high heat-resistive resin such as an acrylic resin, a phenol resin, or the like. The composition may be coated through a spin coating. The composition is cured by heat or UV rays to form the first planarizing layer 115. The first planarizing layer 115 may be thick enough to planarize an upper surface of the substrate.

Examples of a material that may be used for the light-blocking layer 240 may include at least one of a metal, an alloy, an inorganic insulation material, and an organic insulation material. The light-blocking layer 240 may include at least one of silicon-germanium alloy, germanium, and titanium oxide. The light-blocking layer 240 may include silicon-germanium alloy (SiGe). In an exemplary embodiment, the channel may include an oxide semiconductor. The oxide semiconductor is especially susceptible to damage caused by ultraviolet radiation having a wavelength no greater than about 450nm. Silicon-germanium alloy has a high UV-blocking ability. Thus, the light-blocking layer 240 including silicon-germanium alloy may efficiently block ultraviolet radiation generated by a light source or the like, thereby protecting the channel. Silicon-germanium alloy of the light-blocking layer 240 may have an amorphous phase. The light-blocking layer 240 may have a single-layered structure including silicon-germanium alloy or a multiple-layered structure including a silicon-germanium alloy layer and a germanium layer (not shown). The germanium layer may be disposed on or under the silicon-germanium alloy layer.

The thickness of the light-blocking layer 240 may be about 100Å to about 2,000Å. When the thickness of the light-blocking layer 240 is less than about 100Å, a light-blocking ability of the light-blocking pattern may be reduced to such a degree that electrical characteristics are deteriorated. When the thickness of the light-blocking layer 240 is greater than about 2,000Å, the light-blocking pattern may form a capacitance with the source electrode 124 or the drain electrode 126 of the active pattern 120, thereby delaying signal propagation.

The thickness of the light-blocking layer 240 may be about 600Å to about 2,000Å. When the thickness of the light-blocking layer 240 is not less than about 600Å, the light-blocking pattern may have a sufficiently high optical density.

The buffer layer 250 may include an insulation oxide including at least one of silicon oxide, aluminum oxide, hafnium oxide, and yttrium oxide. The thickness of the buffer layer 250 may be about 500Å to about 1 *µ*m.

The oxide semiconductor layer 220 is formed on the buffer layer 250. The oxide semiconductor layer 220 may include a metal oxide semiconductor. For example, the metal oxide semiconductor may include an oxide of zinc, indium, gallium, tin, titanium, phosphor, or combination thereof. The metal oxide semiconductor may include at least one of zinc oxide (ZnO), zinc tin oxide (ZTO), zinc indium oxide (ZIO), indium oxide (InO), titanium oxide (TiO), indium gallium zinc oxide (IGZO), and indium zinc tin oxide (IZTO).

The oxide semiconductor layer 220 may be formed through a chemical vapor deposition (CVD) process, a plasma enhanced chemical vapor deposition (PECVD) process, a solution coating process, or the like.

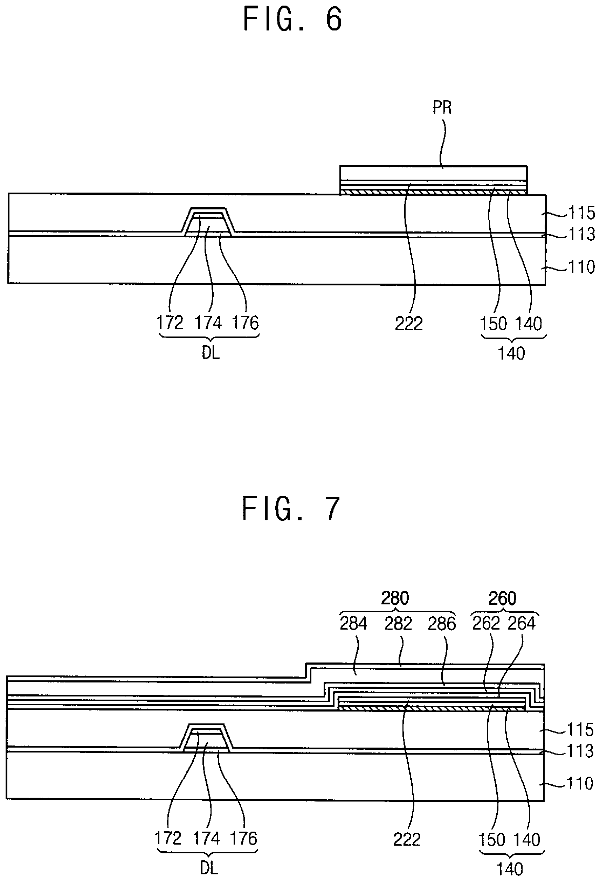

Referring to FIG. 6, the oxide semiconductor layer 220 is patterned to form an oxide semiconductor pattern 222. After a photoresist pattern PR is formed on the oxide semiconductor layer 220, an exposed portion of the oxide semiconductor layer 220 is etched by using the photoresist pattern PR as a mask. Thus, an upper surface of the buffer layer 250 is partially exposed.

Thereafter, the buffer layer 250 and the light-blocking layer 240 are sequentially etched by using the photoresist pattern PR as a mask to form a buffer pattern 150 and a light-blocking pattern 140. Then, the photoresist pattern PR is removed. As a result, the oxide semiconductor pattern 222, the buffer pattern 150, and the light-blocking pattern 140 have a substantially same size and shape in a plan view.

Referring to FIG. 7, a gate insulation layer 260 and a gate metal layer 280 are formed on the oxide semiconductor pattern 222 and the first planarizing layer 115.

The gate insulation layer 260 includes an upper gate insulation layer 262 and a lower gate insulation layer 264. The lower gate insulation layer 264 contacts the oxide semiconductor pattern 222. Thus, the lower gate insulation layer 264 may include a material have relatively small percentage of hydrogen. For example, the lower gate insulation layer 264 may include an insulation oxide including at least one of silicon oxide, aluminum oxide, hafnium oxide, and yttrium oxide, and the thickness of the lower gate insulation layer 264 may be about 500Å to about 3,000Å. The upper gate insulation layer 262 is formed on the lower gate insulation layer 264. The upper gate insulation layer 262 may include silicon nitride or the like, and the thickness of the upper gate insulation layer 262 may be about 500Å to about 2,000Å.

In an exemplary embodiment, the gate insulation layer 260 has a multiple-layered structure, as described above. Alternatively, the gate insulation layer 260 may have a single-layered structure including an insulation oxide such as silicon oxide (not shown).

The gate metal layer 280 includes an upper capping layer 282, a metal layer 284, and a lower capping layer 286. The upper capping layer 282 and the lower capping layer 286 may include an oxide such as IZO, and the metal layer 284 may include a metal such as copper. The gate metal layer 280 may have same constitution as the data metal layer 270. Thus, any duplicative explanation will be omitted.

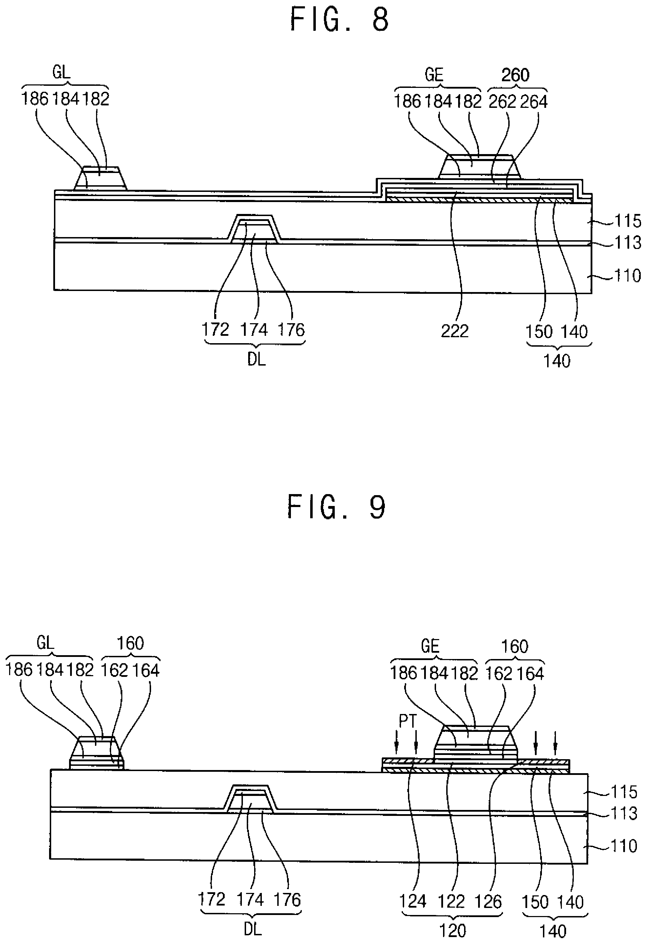

Referring to FIG. 7 and FIG. 8, the gate metal layer 280 is patterned to form a gate electrode GE and a gate line GL.

A photoresist composition may be coated on the upper capping layer 282 to form a photoresist pattern having a shape corresponding to the gate line GL and the gate electrode GE. Thereafter, the upper capping layer 282, the metal layer 284, and the lower capping layer 286, which are not covered by the photoresist pattern, are sequentially etched to form the gate line GL and the gate electrode GE.

The upper capping layer 282, the metal layer 284, and the lower capping layer 286 may be etched in the same process using the same etchant. Thus, the gate line GL may have a relatively large taper angle so that an opening ratio of a display substrate may be increased.

Referring to FIG. 9, the upper gate insulation layer 262 and the lower gate insulation layer 264 are patterned by using the gate electrode GE and the gate line GE as a mask to form a gate insulation pattern 160. Thus, the gate insulation pattern 160 may have substantially same size and shape as the gate line GE and the gate electrode GE.

In the process of patterning the gate insulation layer, the oxide semiconductor pattern 222 is exposed. However, the oxide semiconductor pattern 222 includes a different material from the gate insulation layer 260. Thus, the oxide semiconductor pattern 222 has an etching selectivity with respect to the gate insulation layer, and the oxide semiconductor pattern 222 is not substantially etched when the gate insulation layer is etched.

Thereafter, a channel 122, a source electrode 124, and a drain electrode 126 are formed from the oxide semiconductor pattern 222. A portion of the oxide semiconductor pattern 222, which is not covered by the gate electrode GE and the gate insulation pattern 160, may be turned into the source electrode 124 and the drain electrode 126.

The oxide semiconductor pattern 222 may be plasma-treated to form the source electrode 124 and the drain electrode 126. For example, an exposed portion of the oxide semiconductor pattern 222 is provided with a plasma gas PT of H2, He, PH3, NH3, SiH4, CH4, C2H2, B2H6, CO2, GeH4, H2Se, H2S, Ar, N2, N2O, CHF3, or the like. Accordingly, at least a portion of a semiconductor material included in the oxide semiconductor pattern 222 is reduced to form a metallic conductor. As a result, the reduced portion of the oxide semiconductor pattern 222 forms the source electrode 124 and the drain electrode 126, and a portion of the oxide semiconductor pattern 222, which is covered by the gate electrode GE and the gate insulation pattern 160, remains to function as the channel 122.

Alternatively, the oxide semiconductor pattern 222 may be heated in an atmosphere of a reducing gas, or may be ion-implanted to form the source electrode 124 and the drain electrode 126.

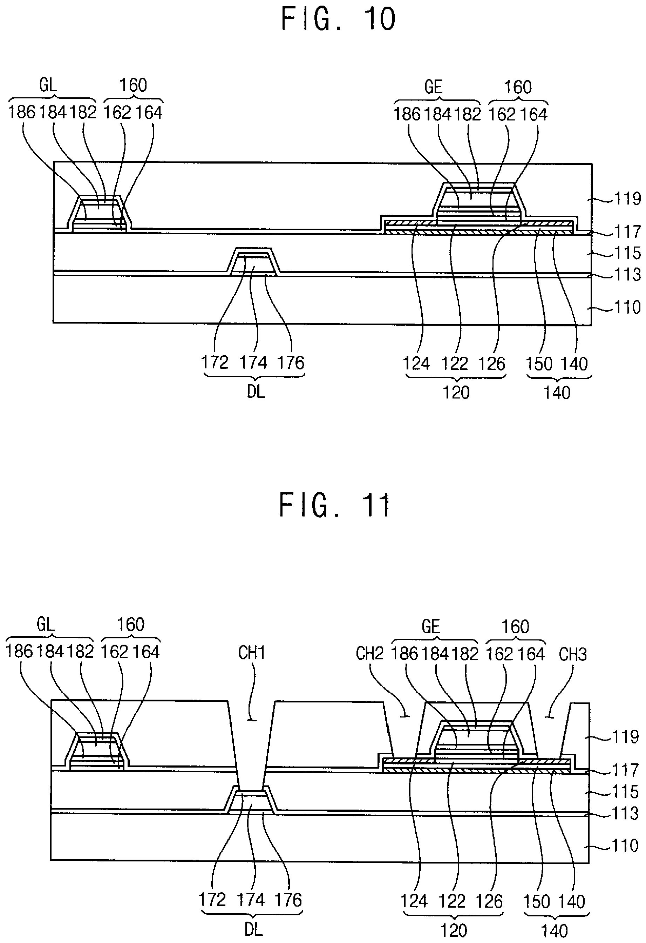

Referring to FIG. 10, a passivation layer 117 is formed to cover the gate electrode GE, the gate line GL, the source electrode 124, the drain electrode 126, and the first planarizing layer 115. A second planarizing layer 119 is formed on the passivation layer 117.

The passiviation layer 117 may include at least one of silicon nitride, silicon oxide, and aluminum oxide. The second planarizing layer 119 planarizes a surface of the substrate. A photoresist composition may be spin-coated on the passivation layer 117 to form the second planarizing layer 119.

Referring to FIG. 11, the data insulation layer 113, the first planarizing layer 115, the passivation layer 117, and the second planarizing layer 119 are patterned to form a plurality of contact holes.

The passivation layer 117 and the second planarizing layer 119 may be patterned to form a second contact hole CH2 exposing a portion of the source electrode 124, and a third contact hole CH3 exposing a portion of the drain electrode 126. The data insulation layer 113 and the first planarizing layer 115 may be further patterned to form a first contact hole CH1 exposing a portion of the data line DL.

The second planarizing layer 119 is exposed to a light. Thereafter, a developer is applied to the second planarizing layer 119 to remove a light-exposed portion or a non light-exposed portion so that the second planarizing layer 119 is patterned. The passivation layer 117, the data insulation layer 113, and the first planarizing layer 115 are etched by using the second planarizing layer 119 as a mask to form the first to third contact holes CH1, CH2, and CH3.

Thereafter, a transparent conductive layer is formed on the second planarizing layer 119. The transparent conductive layer may include at least one of IZO and ITO.

The transparent conductive layer is patterned to form the connection electrode 130 and the pixel electrode PE, which are illustrated in FIG. 2. The connection electrode 130 contacts the data line DL through the first contact hole CH1, and contacts the source electrode 124 through the second contact hole CH2.

As noted above, in an exemplary embodiment, the data line DL is formed separately from the source electrode 124, and the data line DL is electrically connected to the source electrode 124 through the connection electrode 130.

The pixel electrode PE contacts the drain electrode 126 through the third contact hole CH3.

According to the thin film substrate and the method of manufacturing the thin film substrate, a gate electrode is formed on an oxide semiconductor layer, and a source electrode, a drain electrode and a channel are formed from the oxide semiconductor layer by using the gate electrode. Thus, a parasitic capacitance may be reduced.

Furthermore, a light-blocking pattern instead of a gate electrode or a black matrix is formed under a channel including an oxide semiconductor. Thus, the channel is protected from an external light thereby increasing reliability of a thin film transistor.

Furthermore, because an oxide semiconductor pattern and the light-blocking pattern are formed by using a same mask, the number of masks required for manufacturing the thin film transistor may be reduced.

Furthermore, a gate line and/or a data line include an oxide capping layer. Thus, damage to the gate line and/or the data line in a cleaning process using a brush may be prevented, and fine particles formed in the cleaning process may be prevented from deteriorating reliability of the thin film transistor.

Furthermore, the gate line and/or the data line including the oxide capping layer may be etched in the same etchant. Thus, a taper angle of the gate line and/or the data line may be increased. Therefore, an opening ratio of a display panel may be increased.

Furthermore, a planarizing layer is formed to planarize a surface of a substrate so that a step portion produced by a process of forming a data line having a large taper angle may be compensated for. Thus, reliability of manufacturing processes may be improved.

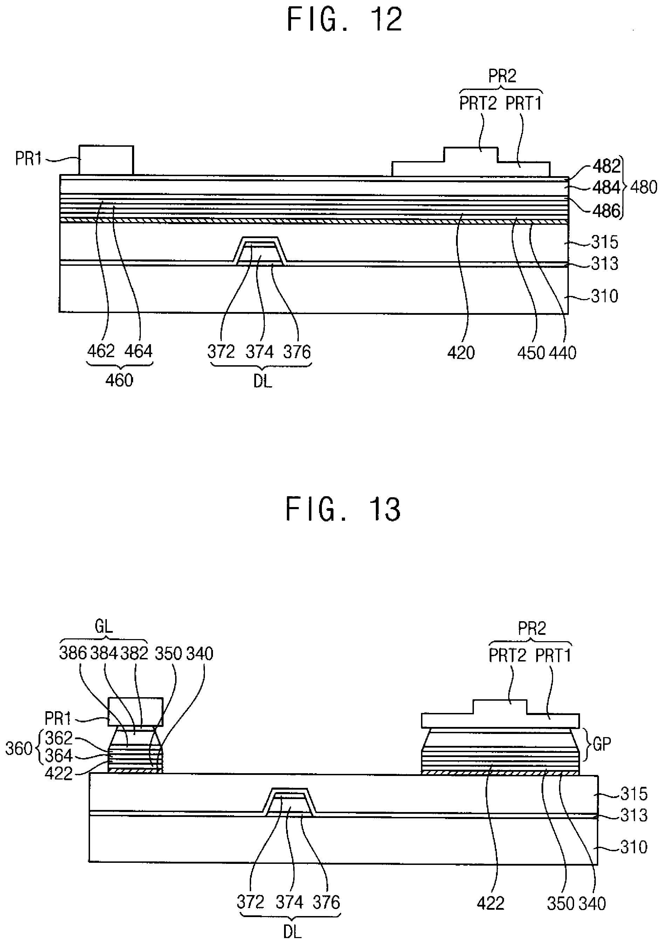

FIGS. 12 to 16 are cross-sectional views illustrating a method of manufacturing a thin film transistor substrate according to another example embodiment of the present invention.

Referring to FIG. 12, a data line DL is formed on a base substrate 310. The data line DL includes an upper capping layer 372, a lower capping layer 376, and a metal layer 374 disposed between the upper capping layer 372 and the lower capping layer 376.

Thereafter, a data insulation layer 313 covering the data line DL is formed, and a first planarizing layer 315, a light-blocking layer 440, a buffer layer 450, and an oxide semiconductor layer 420 are formed on the data insulation layer 313.

The data line DL, the data insulation layer 313, the first planarizing layer 315, the light-blocking layer 440, the buffer layer 450, and the oxide semiconductor layer 420 have substantially the same constitution as those illustrated in FIGs 3 to 5. Thus, any duplicative explanation will be omitted.

Thereafter, a gate insulation layer 460 and a gate metal layer 480 are sequentially formed on the oxide semiconductor layer 420. The gate insulation layer 460 includes an upper gate insulation layer 462 and a lower gate insulation layer 464, and the gate metal layer 480 includes an upper capping layer 482, a lower capping layer 486, and a metal layer 484 disposed between the upper capping layer 482 and the lower capping layer 486.

Thereafter, a photoresist pattern is formed on the gate metal layer through a photolithography process. The photoresist pattern includes a first photoresist pattern PR1 corresponding to a gate line, and a second photoresist pattern PR2 corresponding to an active pattern. The second photoresist pattern PR2 includes a first portion PRT1 and a second portion PRT2 having a different thickness from the first portion PRT1. The first portion PRT1 corresponds to a gate electrode, and the second portion PRT2 corresponds to a source electrode, and a drain electrode. The thickness of the first portion PRT1 is less than the thickness of the second portion PRT2. The thickness of the second portion PRT2 may be substantially same as the thickness of the first photoresist pattern PR1.

A half-tone exposure may be used for forming the second photoresist pattern PR2 having a thickness difference. For example, a negative photoresist composition is coated on the gate metal layer to form a coating layer. A mask that includes a light-blocking area corresponding to an area where the photoresist pattern is not formed, a semi-transmission area corresponding to the second portion PRT2, and a transmission area corresponding to the first portion PRT1 and the first photoresist pattern PR1 is disposed on the coating layer. Thereafter, a light is provided to the coating layer through the mask, and a developer is applied to the coating layer to remove a portion of the coating layer, which corresponds to the light-blocking area. A portion of the coating layer, which corresponds to the transmission area, is not removed. The coating layer under the semi-transmission area is partially removed according to a light-exposure amount so that a photoresist pattern has a thickness difference.

Referring to FIG. 13, the gate metal layer 480 and the gate insulation layer 460 are patterned by using the photoresist pattern as a mask to form a gate line GL and a gate pattern GP.

The gate line GL includes an upper capping layer 382, a metal layer 384 and a lower capping layer 386. The upper capping layer 382, the metal layer 384, and the lower capping layer 386 may be etched in a same process using a same etchant. Thus, the gate line GL may have a relatively large taper angle so that an opening ratio of a display substrate is increased.

A gate insulation pattern 360 formed from the gate insulation layer 460 is disposed under the gate line GL. The gate insulation pattern 360 includes an upper gate insulation pattern 362 and a lower gate insulation pattern 364.

The gate pattern GP is formed from the gate metal layer 480 and the gate insulation layer 460, and includes patterns having a shape corresponding to the second photoresist pattern PR2.

Thereafter, the oxide semiconductor layer 420, the buffer layer 450 and the light-blocking layer 440 are etched to form an oxide semiconductor pattern 422, a buffer pattern 350, and a light-blocking pattern 340. As a result, the first planarizing layer 315 may be partially exposed.

In an exemplary embodiment, the oxide semiconductor layer 420, the buffer layer 450, and the light-blocking layer 440 are etched after the gate metal layer 480 and the gate insulation layer 460 are etched. Thus, the oxide semiconductor pattern 422, the buffer pattern 350, and the light-blocking pattern 340 are formed under the gate line GL as well as the gate pattern GP.

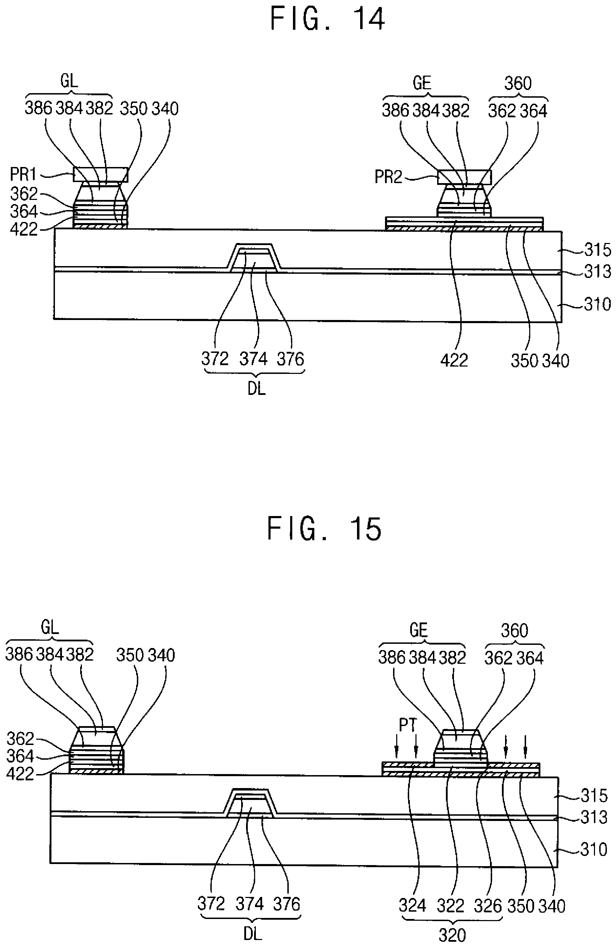

Referring to FIG. 14, the photoresist pattern is partially removed through, for example, an ashing process. The thickness of the photoresist pattern may be entirely reduced. As a result, the first portion PRT1 of the second photoresist pattern PR2, which is thinner than the second portion PRT2, is removed so that an upper surface of the gate pattern GP is partially exposed.

Thereafter, an exposed portion of the gate pattern GP is etched by using the second photoresist pattern PR2 to form a gate electrode GE and a gate insulation pattern 360. The gate electrode GE includes an upper capping layer 382, a metal layer 384, and a lower capping layer 386, and the gate insulation pattern 360 includes an upper gate insulation pattern 362 and a lower gate insulation pattern 364.

As a portion of the gate pattern GP is removed, a portion of the oxide semiconductor pattern 422 is exposed.

Referring to FIG. 15, after the photoresist pattern is removed, a portion of the oxide semiconductor pattern 422, which is not covered by the gate electrode GE and the gate insulation pattern 360, is turned into a source electrode 324 and a drain electrode 326. For example, a plasma gas PT may be applied to an exposed portion of the oxide semiconductor pattern 422 to form the source electrode 324 and the drain electrode 326. Accordingly, at least a portion of a semiconductor material included in the oxide semiconductor pattern 422 is reduced to form a metallic conductor. As a result, the reduced portion of the oxide semiconductor pattern 422 forms the source electrode 324 and the drain electrode 326, and a portion of the oxide semiconductor pattern 222, which is not reduced, remains to forms a channel. Accordingly, an active pattern 320 including the source electrode 324, the drain electrode 326, and the channel 322, which are formed from the same layer, is formed.

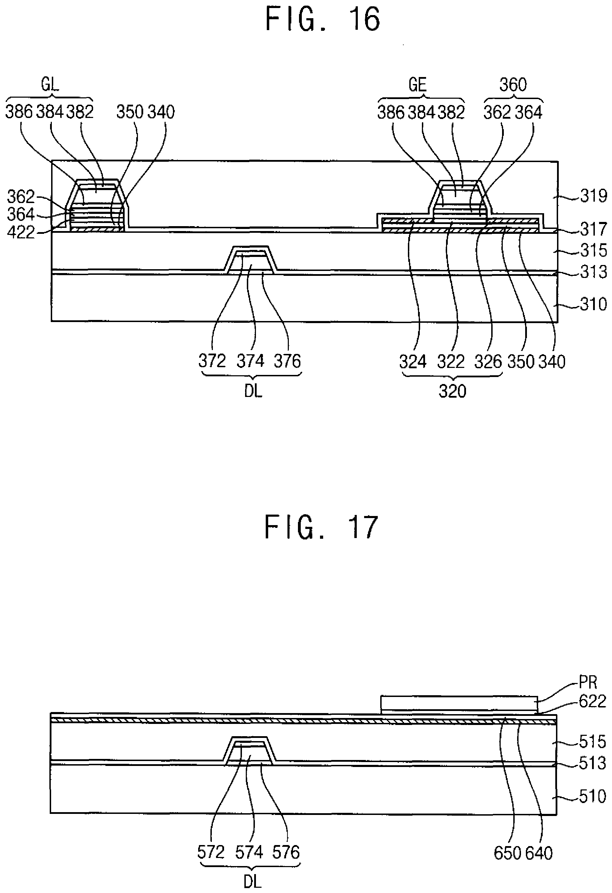

Referring to FIG. 16, a passivation layer 317 is formed to cover the gate electrode GE, the gate line GL, the source electrode 324, the drain electrode 326, and the first planarizing layer 315, and a second planarizing layer 319 is formed on the passivation layer 317.

Thereafter, the data insulation layer 313, the first planarizing layer 315, the passivation layer 317, and the second planarizing layer 319 are patterned to form a plurality of contact holes exposing the data line DL, the source electrode 324 and the drain electrode 326. Thereafter, a connection electrode electrically connecting the data line DL to the source electrode 324, and a pixel electrode electrically connected to the drain electrode 326 are formed. The contact holes, the connection electrode and the pixel electrode may be formed through substantially same processes as those illustrated in FIGs. 10 and 11. Thus, any duplicative explanation will be omitted.

According to the method of manufacturing a thin film transistor substrate, the gate electrode GE, the oxide semiconductor layer 422, the buffer layer 450, and the light-blocking layer 440 may be patterned by using the same mask. Thus, the number of masks required for manufacturing the thin film transistor may be reduced.

FIGs. 17 to 21 are cross-sectional views illustrating a method of manufacturing a thin film transistor substrate according to still another exemplary embodiment of the present invention.

Referring to FIG. 17, a data line DL is formed on a base substrate 510. The data line DL includes an upper capping layer 572, a lower capping layer 576, and a metal layer 574 disposed between the upper capping layer 572 and the lower capping layer 576.

Thereafter, a data insulation layer 513 covering the data line DL is formed, and a first planarizing layer 515, a light-blocking layer 640, a buffer layer 650, and an oxide semiconductor layer are formed on the data insulation layer 513.

The data line DL, the data insulation layer 513, the first planarizing layer 515, the light-blocking layer 640, the buffer layer 650, and the oxide semiconductor layer have substantially the same constitution as those illustrated in FIGS. 3 to 5. Thus, any duplicative explanation will be omitted.

Thereafter, the oxide semiconductor layer is patterned to form an oxide semiconductor pattern 622. Particularly, a photoresist pattern PR is formed on the oxide semiconductor layer, and the oxide semiconductor layer is etched by using the photoresist pattern PR.

In the process of etching the oxide semiconductor layer, the buffer layer 650 is exposed. However, the buffer layer 650 includes a different material from the oxide semiconductor layer. Thus, the buffer layer 650 has an etching selectivity with respect to the oxide semiconductor layer, and the buffer layer 650 is not substantially etched when the oxide semiconductor layer is etched.

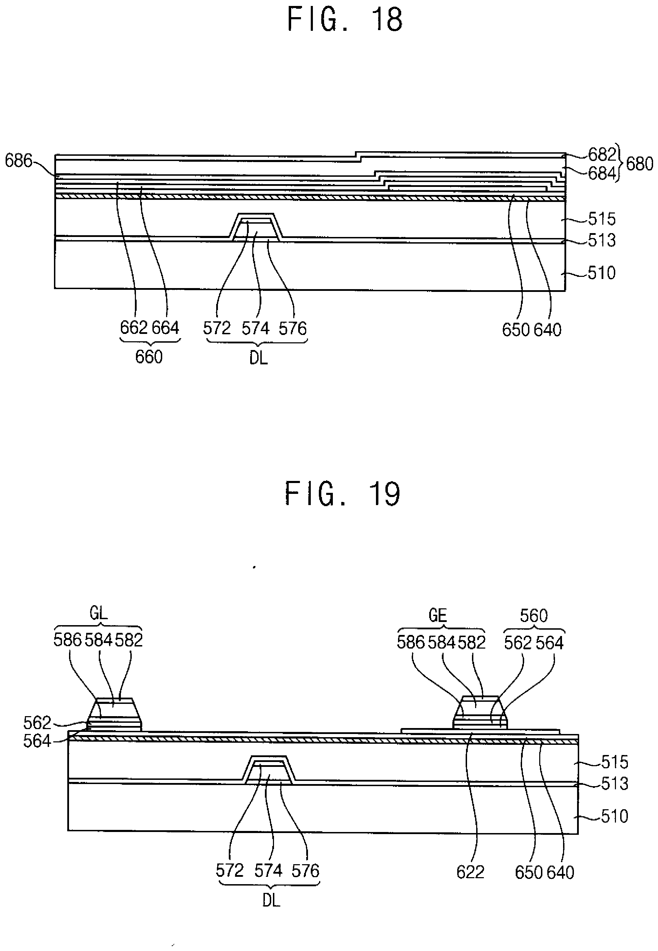

Referring to FIG. 18, a gate insulation layer 660 and a gate metal layer are sequentially formed on the oxide semiconductor pattern 622 and the buffer layer 650. The gate insulation layer 660 includes an upper gate insulation layer 662 and a lower gate insulation layer 664, and the gate metal layer 680 includes an upper capping layer 682, a lower capping layer 686, and a metal layer 684 disposed between the upper capping layer 682 and the lower capping layer 686.

Referring to FIG. 19, the gate insulation layer 660 and the gate metal layer 680 are patterned to form a gate electrode GE, a gate line GL, and a gate insulation pattern 560. A photoresist pattern (not shown) having a shape corresponding to the gate electrode GE and the gate line GL may be formed on the gate metal layer 680. Thereafter, the gate insulation layer 660 and the gate metal layer 680 are etched by using the photoresist pattern as a mask.

In the process of etching the gate insulation layer 660, the oxide semiconductor pattern 622 is exposed. However, the oxide semiconductor pattern 622 includes a different material from the gate metal layer 680 and the gate insulation layer 660. Thus, the oxide semiconductor pattern 622 has an etching selectivity with respect to the gate metal layer 680 and the gate insulation layer 660, and the oxide semiconductor pattern 622 is not substantially etched when the gate insulation layer 660 and the gate metal layer 680 are etched.

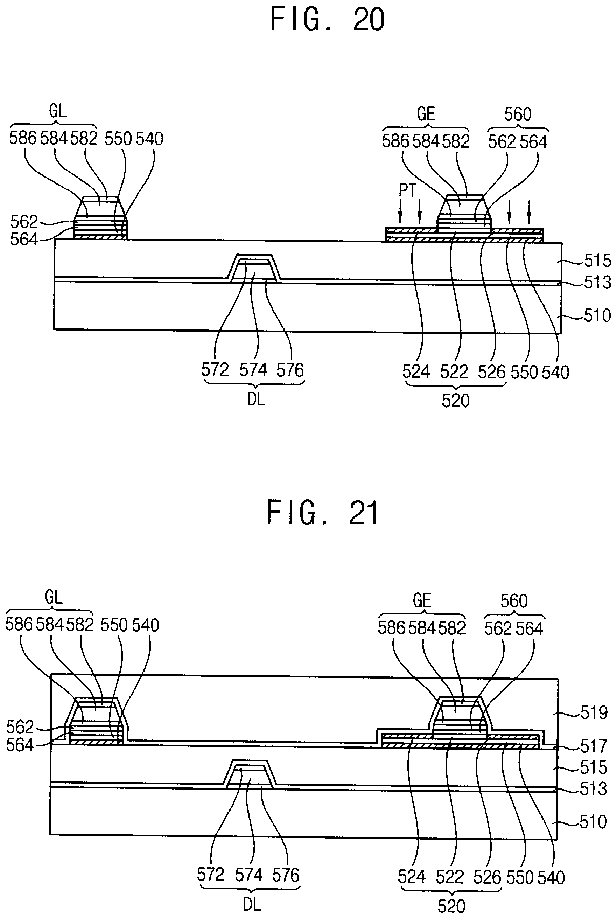

Referring to FIG. 20, the buffer layer 650 and the light-blocking layer 640 are patterned to form a buffer pattern 550 and a light-blocking pattern 540. The buffer layer 650 and the light-blocking layer 640 are etched by using the gate line GL and the oxide semiconductor pattern 622 as a mask. In this manner, each of the buffer pattern 550 and the light-blocking pattern 540 may have a size larger than the oxide semiconductor pattern 622 in a plan view.

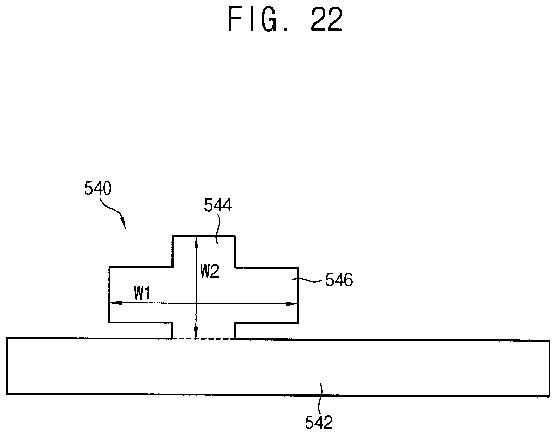

FIG. 22 is a plan view illustrating a light-blocking pattern of the thin film transistor illustrated in FIG. 20. The light-blocking pattern 540 may overlap with an entire portion of the oxide semiconductor pattern 622 and an entire portion of the gate electrode GE. Referring to FIG. 22, the light-blocking pattern 540 includes a first portion 542, which overlaps with the gate line GL, a second portion 544, which extends from the first portion 542 and overlaps with the gate electrode GE, and a third portion 546, which extends from the second portion 544 and overlaps with the oxide semiconductor pattern 622.

The first portion 542 may extend in the first direction D1, and the second portion 544 may extend in the second direction D2, and the third portion 546 may extend in the first direction D1. In a plan view, an edge of the second portion 544 substantially coincides with an edge of the gate electrode GE, and an edge of the third portion 546 substantially coincides with an edge of the oxide semiconductor pattern 622. Thus, a width W1 of the light-blocking pattern 540, which overlaps with the oxide semiconductor pattern 622, in the first direction is substantially same as a width of the oxide semiconductor pattern 622 in the first direction. Furthermore, a width W2 of the light-blocking pattern 540, which overlaps with the gate electrode GE, in the second direction is substantially same as a width of the gate electrode GE in the second direction.

The buffer pattern 550 has substantially the same shape as the light-blocking pattern 540 in a plan view.

Thereafter, the a portion of the oxide semiconductor pattern 622, which is not covered by the gate electrode GE and the gate insulation pattern 560, is turned into a source electrode 524 and a drain electrode 526. For example, a plasma gas PT may be applied to an exposed portion of the oxide semiconductor pattern to form the source electrode 524 and the drain electrode 526. As a result, a plasma-treated portion of the oxide semiconductor pattern 622 forms the source electrode 524 and the drain electrode 526, and a portion of the oxide semiconductor pattern 622, which is covered by the gate electrode GE and the gate insulation pattern 560 not to be reduced, remains to form a channel. Accordingly, an active pattern 520 including the source electrode 524, the drain electrode 526 and the channel 522, which are formed from a same layer, is formed.

Alternatively, the source electrode 524 and the drain electrode 526 may be formed before the buffer layer 650 and the light-blocking layer 640 are patterned.

Referring to FIG. 21, a passivation layer 517 is formed to cover the gate electrode GE, the gate line GL, the source electrode 524, the drain electrode 526, and the first planarizing layer 515, and a second planarizing layer 519 is formed on the passivation layer 517.

Thereafter, the data insulation layer 513, the first planarizing layer 515, the passivation layer 517, and the second planarizing layer 519 are patterned to form a plurality of contact holes exposing the data line DL, the source electrode 524, and the drain electrode 526. Thereafter, a connection electrode electrically connecting the data line DL to the source electrode 524, and a pixel electrode electrically connected to the drain electrode 526 are formed. The contact holes, the connection electrode and the pixel electrode may be formed through substantially same processes as those illustrated in FIGS. 10 and 11. Thus, any duplicative explanation will be omitted.

According to the method of manufacturing a thin film transistor substrate illustrated in FIGS. 12 to 21, the light-blocking patterns 340 and 540 overlap with the gate electrode GE and the gate line GL, as well as the active patterns 320 and 520. Thus, a light-blocking area is reduced so that reliability of a thin film transistor is increased.

The thin film transistor substrate and the method of manufacturing the thin film transistor substrate may be used for a display device and an electronic device such as a liquid crystal display, an organic EL display, a circuit board including a thin film transistor, a semiconductor device, or the like.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

## Claims

1. A thin film transistor substrate comprising:
a substrate (110);
an active pattern (120) disposed on the substrate (110) and comprising a source electrode (124), a drain electrode (126), and a channel (122) comprising an oxide semiconductor disposed between the source electrode (124) and the drain electrode (126);
a gate insulation pattern (160) disposed on the active pattern (120);
a gate electrode (GE) disposed on the gate insulation pattern (160) and overlapping with the channel (122);
a gate line (GL) electrically connected to the gate electrode (GE);
a data line (DL) electrically connected to the source electrode (124);
a pixel electrode (PE) electrically connected to the drain electrode (126); and
a light-blocking pattern (140) disposed between the substrate (110) and the active pattern (120);
wherein
the thin film transistor further comprises a first planarizing layer (115) including an organic material, disposed on the data line(DL) and compensating for a step portion resulting from the data line (DL),
the active pattern (120) and the light-blocking pattern (140) are disposed on the first planarizing layer (115), and
the data line (DL) is connected to the source electrode (124) through a connection electrode (130) including a transparent conductive material.

2. The thin film transistor substrate of claim 1, wherein the oxide semiconductor comprises at least one selected from the group consisting of zinc oxide (ZnO), zinc tin oxide (ZTO), zinc indium oxide (ZIO), indium oxide (InO), titanium oxide (TiO), indium gallium zinc oxide (IGZO), and indium zinc tin oxide (IZTO).

3. The thin film transistor substrate of claim 3, wherein at least one of the gate line (GL) and the data line (DL) comprises an upper capping layer (172, 182), a lower capping layer (176, 186), and a metal layer (174, 184) disposed between the upper capping layer (172, 182) and the lower capping layer (176, 186), and
the upper capping layer (172, 182) and the lower capping layer (176, 186) comprise an oxide having Moh's hardness equal to or greater than about 4.0.

4. The thin film transistor substrate of claim 3, wherein the metal layer (174, 184) comprises copper, and the upper capping layer (172, 182) and the lower capping layer (176, 186) comprise indium zinc oxide.

5. The thin film transistor substrate of claim 4, wherein at least one of the gate line (GL) and the data line (DL) have a taper angle equal to or greater than about 60°.

6. The thin film transistor substrate of claim 1, further comprising:
a data insulation layer (113) including an inorganic material and covering the data line (DL).

7. The thin film transistor of claim 1, further comprising:
a passivation layer (117) including at least one of silicon nitride, silicon oxide, and aluminum oxide and covering the gate electrode (GE), the gate line (GL), the active pattern (120), and the first planarizing layer (115); and
a second planarizing layer (119) including a photoresist composition and disposed on the passivation layer (117).

8. The thin film transistor substrate of claim 7, wherein the connection electrode (130) is connected to the data line (DL) through a first contact hole (CH1) formed through the data insulation layer (113), the first planarizing layer (115), the passivation layer (117), and the second planarizing layer (119), and connected to the source electrode (124) through a second contact hole (CH2) formed through the passivation layer (117) and the second planarizing layer (119).

9. The thin film transistor substrate of claim 1, further comprising a buffer pattern (150) disposed between the light-blocking pattern (140) and the active pattern (120).

10. The thin film transistor substrate (100) of claim 8, wherein the light-blocking pattern (140) comprises at least one selected from the group consisting of silicon oxide, silicon-germanium alloy, germanium, and titanium oxide.

11. The thin film transistor substrate (100) of claim 10, wherein the active pattern (120) has a same shape as the light-blocking pattern (140) in a plan view.

12. The thin film transistor substrate (100) of claim 10, wherein the light-blocking pattern (140) has a size larger than the active pattern (120) in a plan view, and the light-blocking pattern (140) overlaps with an entire portion of the gate electrode (GE) and an entire portion of the active pattern (120).

## Patentansprüche

1. Dünnschichttransistor-Substrat, umfassend:
ein Substrat (110);
ein aktives Muster (120), das auf dem Substrat (110) angeordnet ist und Folgendes umfasst: eine Source-Elektrode (124), eine Drain-Elektrode (126) und einen Kanal (122), der einen Oxid-Halbleiter umfasst, der zwischen der Source-Elektrode (124) und der Drain-Elektrode (126) angeordnet ist;
ein Gate-Isolierungsmuster (160), das auf dem aktiven Muster (120) angeordnet ist;
eine Gate-Elektrode (GE), die auf dem Gate-Isolierungsmuster (160) angeordnet ist und sich mit dem Kanal (122) überlappt;
eine Gate-Leitung (GL), die mit der Gate-Elektrode (GE) elektrisch verbunden ist;
eine Datenleitung (DL), die mit der Source-Elektrode (124) elektrisch verbunden ist;
eine Pixelelektrode (PE), die mit der Drain-Elektrode (126) elektrisch verbunden ist; und
ein lichtblockierendes Muster (140), das zwischen dem Substrat (110) und dem aktiven Muster (120) angeordnet ist; wobei
der Dünnschichttransistor ferner eine erste Einebnungsschicht (115) umfasst, die ein organisches Material enthält, auf der Datenleitung (DL) angeordnet ist und einen Stufenabschnitt kompensiert, der aus der Datenleitung (DL) resultiert,
das aktive Muster (120) und das lichtblockierende Muster (140) auf der ersten Einebnungsschicht (115) angeordnet sind, und
die Datenleitung (DL) mit der Source-Elektrode (124) durch eine Verbindungselektrode (130) verbunden ist, die ein transparentes leitendes Material enthält.

2. Dünnschichttransistor-Substrat nach Anspruch 1, wobei der Oxid-Halbleiter wenigstens eines umfasst, das aus der Gruppe ausgewählt ist, die aus Zinkoxid (ZnO), Zink-Zinn-Oxid (ZTO), Zink-Indium-Oxid (ZIO), Indiumoxid (InO), Titanoxid (TiO), Indium-Gallium-Zinkoxid (IGZO) und Indium-Zink-Zinn-Oxid (IZTO) besteht.

3. Dünnschichttransistor-Substrat nach Anspruch 3, wobei wenigstens eine aus der Gate-Leitung (GL) und der Datenleitung (DL) eine obere Abdeckschicht (172, 182), eine untere Abdeckschicht (176, 186) und eine Metallschicht (174, 184) umfasst, die zwischen der oberen Abdeckschicht (172, 182) und der unteren Abdeckschicht (176, 186) angeordnet ist, und die obere Abdeckschicht (172, 182) und die untere Abdeckschicht (176, 186) ein Oxid umfassen, das eine Mohshärte von gleich oder größer als etwa 4,0 aufweist.

4. Dünnschichttransistor-Substrat nach Anspruch 3, wobei die Metallschicht (174, 184) Kupfer umfasst und die obere Abdeckschicht (172, 182) und die untere Abdeckschicht (176, 186) Indium-Zink-Oxid umfassen.

5. Dünnschichttransistor-Substrat nach Anspruch 4, wobei wenigstens eine aus der Gate-Leitung (GL) und der Datenleitung (DL) einen Kegelwinkel von gleich oder größer als etwa 60° aufweist.

6. Dünnschichttransistor-Substrat nach Anspruch 1, ferner umfassend:
eine Datenisolierschicht (113), die ein anorganisches Material enthält und die Datenleitung (DL) bedeckt.

7. Dünnschichttransistor nach Anspruch 1, ferner umfassend:
eine Passivierungsschicht (117), die wenigstens eines aus Siliciumnitrid, Siliciumoxid und Aluminiumoxid enthält und die Gate-Elektrode (GE), die Gate-Leitung (GL), das aktive Muster (120) und die erste Einebnungsschicht (115) bedeckt; und
eine zweite Einebnungsschicht (119), die eine Photolackzusammensetzung enthält und auf der Passivierungsschicht (117) angeordnet ist.

8. Dünnschichttransistor-Substrat nach Anspruch 7, wobei die Verbindungselektrode (130) mit der Datenleitung (DL) durch ein erstes Kontaktloch (CH1) verbunden ist, das durch die Datenisolierschicht (113), die erste Einebnungsschicht (115), die Passivierungsschicht (117) und die zweite Einebnungsschicht (119) gebildet ist, und mit der Source-Elektrode (124) durch ein zweites Kontaktloch (CH2) verbunden ist, das durch die Passivierungsschicht (117) und die zweite Einebnungsschicht (119) gebildet ist.

9. Dünnschichttransistor-Substrat nach Anspruch 1, ferner umfassend ein Puffermuster (150), das zwischen dem lichtblockierenden Muster (140) und dem aktiven Muster (120) angeordnet ist.

10. Dünnschichttransistor-Substrat (100) nach Anspruch 8, wobei das lichtblockierende Muster (140) wenigstens eines umfasst, das aus der Gruppe ausgewählt ist, die aus Siliciumoxid, einer Silicium-Germanium-Legierung, Germanium und Titanoxid besteht.

11. Dünnschichttransistor-Substrat (100) nach Anspruch 10, wobei das aktive Muster (120) in Draufsicht die gleiche Form wie das lichtblockierende Muster (140) aufweist.

12. Dünnschichttransistor-Substrat (100) nach Anspruch 10, wobei das lichtblockierende Muster (140) in Draufsicht eine Größe aufweist, die größer als jene des aktiven Musters (120) ist und wobei sich das lichtblockierende Muster (140) mit einem gesamten Abschnitt der Gate-Elektrode (GE) und einem gesamten Abschnitt des aktiven Musters (120) überlappt.

## Revendications

1. Substrat de transistor à couches minces comprenant :
un substrat (110) ;
un tracé actif (120) disposé sur le substrat (110) et comprenant une électrode de source (124), une électrode de drain (126) et un canal (122) comprenant un semi-conducteur à oxyde disposé entre l'électrode de source (124) et l'électrode de drain (126) ;
un tracé d'isolation de grille (160) disposé sur le tracé actif (120) ;
une électrode de grille (GE) disposée sur le tracé d'isolation de grille (160) et chevauchant le canal (122) ;
une ligne de grille (GL) connectée électriquement à l'électrode de grille (GE) ;
une ligne de données (DL) connectée électriquement à l'électrode de source (124) ;
une électrode de pixel (PE) connectée électriquement à l'électrode de drain (126) ;
et
un tracé occultant la lumière (140) disposé entre le substrat (110) et le tracé actif (120) ;
dans lequel
le transistor à couches minces comprend en outre une première couche de planarisation (115) comprenant un matériau organique, disposée sur la ligne de données (DL) et compensant une partie en gradin résultant de la ligne de données (DL),
le tracé actif (120) et le tracé occultant la lumière (140) sont disposés sur la première couche de planarisation (115), et
la ligne de données (DL) est connectée à l'électrode de source (124) par une électrode de connexion (130) comprenant un matériau conducteur transparent.

2. Substrat de transistor à couches minces selon la revendication 1, dans lequel le semi-conducteur à oxyde comprend au moins un semi-conducteur choisi parmi le groupe comprenant l'oxyde de zinc (ZnO), l'oxyde de zinc et d'étain (ZTO), l'oxyde de zinc et d'indium (ZIO), l'oxyde d'indium (InO), l'oxyde de titane (TiO), l'oxyde d'indium, gallium et zinc (IGZO) et l'oxyde d'indium, zinc et étain (IZTO).

3. Substrat de transistor à couches minces selon la revendication 3, dans lequel au moins soit la ligne de grille (GL), soit la ligne de données (DL) comprend une couche de couverture supérieure (172, 182), une couche de couverture inférieure (176, 186) et une couche métallique (174, 184) disposée entre la couche de couverture supérieure (172, 182) et la couche de couverture inférieure (176, 186), et
la couche de couverture supérieure (172, 182) et la couche de couverture inférieure (176, 186) comprennent un oxyde ayant une dureté Moh égale ou supérieure à environ 4,0.

4. Substrat de transistor à couches minces selon la revendication 3, dans lequel la couche métallique (174, 184) comprend du cuivre et la couche de couverture supérieure (172, 182) et la couche de couverture inférieure (176, 186) comprennent de l'oxyde d'indium et de zinc.

5. Substrat de transistor à couches minces selon la revendication 4, dans lequel au moins soit la ligne de grille (GL), soit la ligne de données (DL) a un angle de conicité égal ou supérieur à 60° environ.

6. Substrat de transistor à couches minces selon la revendication 1, comprenant en outre une couche d'isolation des données (113) comprenant un matériau organique et couvrant la ligne de données (DL).

7. Transistor à couches minces selon la revendication 1, comprenant en outre une couche de passivation (117) qui contient au moins soit du nitrure de silicium, soit de l'oxyde de silicium, soit de l'oxyde d'aluminium et couvre l'électrode de grille (GE), la ligne de grille (GL), le tracé actif (120) et la première couche de planarisation (115) et
une deuxième couche de planarisation (119) comprenant une composition photorésistante et disposée sur la couche de passivation (117).

8. Substrat de transistor à couches minces selon la revendication 7, dans lequel l'électrode de connexion (130) est connectée à la ligne de données (DL) à travers un premier trou de contact (CH1) formé à travers la couche d'isolation de données (113), la première couche de planarisation (115), la couche de passivation (117) et la deuxième couche de planarisation (119) et connectée à l'électrode de source (124) à travers un deuxième trou de contact (CH2) formé à travers la couche de passivation (117) et la deuxième couche de planarisation (119).

9. Substrat de transistor à couches minces selon la revendication 1, comprenant en outre un tracé de tampon (150) disposé entre le tracé occultant la lumière (140) et le tracé actif (120).

10. Substrat de transistor à couches minces (100) selon la revendication 8, dans lequel le tracé occultant la lumière (140) comprend au moins un composé choisi parmi le groupe comprenant l'oxyde de silicium, un alliage de silicium et de germanium, le germanium et un oxyde de titane.

11. Substrat de transistor à couches minces (100) selon la revendication 10, dans lequel le tracé actif (120) a la même forme que le tracé occultant la lumière (140) dans une vue en plan.

12. Substrat de transistor à couches minces (100) selon la revendication 10, dans lequel le tracé occultant la lumière (140) est plus grand que le tracé actif (120) dans une vue en plan, et le tracé occultant la lumière (140) chevauche une partie entière de l'électrode de grille (GE) et une partie entière du tracé actif (120).
